# EUROPÄISCHE PATENTSCHRIFT

(11) **EP 3 729 645 B1**
(45) Veröffentlichungstag und Bekanntmachung des Hinweises auf die Patenterteilung: **01.06.2022**
(21) Anmeldenummer: 18811822.8
(22) Anmeldetag: 30.11.2018
(51) Int. Cl.: H03H 1/00, H03H 7/01, H03H 7/42, H01F 27/28, H01F 27/29, H01F 17/06, H01F 27/32

(54) **LC-FILTERANORDNUNG UND ELEKTRISCHES ODER ELEKTRONISCHES GERÄT MIT EINER DERARTIGEN LC-FILTERANORDNUNG**
LC-FILTER ARRANGEMENT AND ELECTRICAL OR ELECTRONICAL DEVICE COMPRISING SUCH AN LC-FILTER ARRANGEMENT
ARRANGEMENT D'UN FILTRE LC, DISPOSITIF ELECTRIQUE OU ELECTRONIQUE COMPRENANT UN ARRANGEMENT D'UN TEL FILTRE LC

(30) Priorität: 21.12.2017 DE 102017131045
(43) Veröffentlichungstag der Anmeldung: 28.10.2020
(73) Patentinhaber: SMA Solar Technology AG, 34266 Niestetal (DE)
(72) Erfinder: FRIEBE, Jens, 34246 Vellmar (DE)
(86) Internationale Anmeldenummer: PCT/EP2018/083230
(87) Internationale Veröffentlichungsnummer: WO 2019/120952

(56) Entgegenhaltungen:
- US-A- 4 777 465
- US-A- 5 243 308
- US-A1- 2013 285 763
- US-A1- 2016 172 310

## Beschreibung

### TECHNISCHES GEBIET DER ERFINDUNG

Die Erfindung bezieht sich auf eine LC-Filteranordnung, sowie ein elektrisches oder elektronisches Gerät mit einer derartigen LC-Filteranordnung. Unter einer LC-Filteranordnung ist eine Schaltungseinheit zu verstehen, die aus einem Gemisch eines Nutzsignals und eines oder mehrerer Störsignale den Anteil der unerwünschten Störsignale reduziert, idealerweise eliminiert. Dabei soll das Nutzsignal möglichst wenig gedämpft werden. Bei der Reduktion bzw. Dämpfung der Störsignale wird eine frequenzabhängige Impedanz von induktiv, wie auch kapazitiv wirkenden Bauteilen ausgenutzt. Eine LC-Filteranordnung wird beispielsweise als sogenannter Sinusfilter am Ausgang eines ausgangsseitig an ein Energieversorgungsnetz angeschlossenen Photovoltaik (PV) - Wechselrichters eingesetzt, um zu verhindern, dass Störsignale in unerwünschter Höhe in das Energieversorgungsnetz eingespeist werden. Die erfindungsgemäße LC-Filteranordnung weist dabei im Vergleich zu herkömmlichen LC-Filteranordnungen eine besonders hohe Reproduzierbarkeit ihrer Filtereigenschaften auf. Die Filtereigenschaften lassen sich einem gewünschten Verlauf auch noch in einem relativ späten Stadium in der Herstellung der LC-Filteranordnung anpassen, wobei die erfindungsgemäße LC-Filteranordnung besonders kostengünstig herstellbar ist.

### STAND DER TECHNIK

Ein elektrisches oder elektronisches Gerät kann Störsignale einerseits über als Antennen wirkende Bauteile des Geräts aus der Umgebung einfangen. Andererseits können Störsignale jedoch auch von dem Gerät selbst, beispielsweise aufgrund hochfrequenter Schalthandlungen, erzeugt werden. Die Störsignale sind im Allgemeinen unerwünscht und können im Gerät selbst oder in daran angeschlossenen Baugruppen zu einem fehlerhaften Betrieb führen. Daher wird sowohl der Empfang als auch die Weiterleitung von Störsignalen durch das Gerät durch geeignete Maßnahmen reduziert. Beispielsweise ist eine erlaubte Einspeisung von hochfrequenten Störsignalen eines an ein Energieversorgungsnetz angeschlossenen Photovoltaik (PV) - Wechselrichters durch entsprechende Normen begrenzt.

Um ein Einfangen von externen Störsignalen und/oder eine Ausbreitung von in dem Gerät vorhandenen Störsignalen zu reduzieren, ist der Einsatz von LC-Filtern an Eingängen bzw. Ausgängen des Gerätes bekannt. Oftmals ist eine gewünschte Dämpfung der Störsignale in einem bestimmten Frequenzbereich jedoch nur über mehrstufige LC-Filter zu realisieren. Dies liegt zum einen daran, dass eine Filterwirkung eines einstufigen Filters von üblicherweise 40 db pro Dekade nicht ausreichend ist, einen Störsignalpegel in dem relevanten Frequenzbereich auf das gewünschte Maß hin zu dämpfen. Zum anderen führt eine stets vorhandene parasitäre Windungskapazität einer Filterdrossel dazu, dass eine Filterwirkung der Filterdrossel ab Frequenzen oberhalb einer Grenzfrequenz stagniert. Hier werden höherfrequente Anteile des Störsignals über eine prinzipbedingt stets vorhandene parasitäre Windungskapazität der Filterdrossel kurzgeschlossen.

Mehrstufige LC-Filter umfassen eine kaskadierte Verschaltung einstufiger LC-Filter. Sie sind aufgrund einer höheren Komponentenanzahl üblicherweise kostenintensiver und nehmen einen größeren Bauraum ein, was sich nochmals auf die Kosten des Gerätes auswirkt. Ein weiterer Kostenfaktor ist ein aufwendig - oftmals manuell - gestalteter Wickelprozess der Drosseln herkömmlicher LC-Filter. Der Wickelprozess führt gleichzeitig zu einer nur eingeschränkten

Reproduzierbarkeit - und damit zu einer großen Toleranz - der Filterparameter verschiedener LC-Filter des gleichen Typs. Eine nachträgliche Anpassung einer Filterwirkung eines einmal ausgelegten LC-Filters ist nur schwer möglich. Daher ist ein zumindest hinsichtlich dieser Eigenschaften optimierter LC-Filter wünschenswert.

Die Schrift US 2009 / 0160596 A1 beschreibt eine magnetische Vorrichtung, die eine Leiterplatte, ein magnetisches Induktionselement, eine isolierende Struktur und mehrere leitfähige Drahtsegmente umfasst. Das von der isolierenden Struktur bedeckte magnetische Induktionselement ist auf der Leiterplatte angeordnet. Die Leiterplatte weist eine leitfähige Schicht auf, wobei zwei Enden von jedem leitfähigen Drahtsegment elektrisch mit der leitfähigen Schicht verbunden sind, um eine Spulenschleife zu bilden.

Die Schrift DE 11 2016 002174 T5 offenbart ein Störungsfilter mit einer gedruckten Leiterplatte, auf der ein Verdrahtungsmuster ausgebildet ist, und einer einen toroidförmigen Kern aufweisenden Drosselspule. Bei Betrachtung der toroidförmigen Drosselspule in der Draufsicht ist an einer Position der gedruckten Leiterplatte, die einen hohlen Bereich der Drosselspule überlappt, ein Gehäusemassenbereich ausgebildet. Das Störungsfilter umfasst ferner einen Kondensator, dessen erster Anschluss mit dem Gehäusemassenbereich durch das Verdrahtungsmuster verbunden ist.

Die Schrift DE 10 2016 224472 A1 offenbart eine Stromrichtereinrichtung für ein Kraftfahrzeug. Eine Schalteinheit, die mit einer vorgegebenen Schaltfrequenz betreibbar ist, ist mit einem Zwischenkreis der Stromrichtereinrichtung verbunden. In dem Zwischenkreis sind mehrere Filterelemente verschaltet, die jeweils eine Zwischenkreiskapazität aufweisen. Die Filterelemente sind so ausgelegt, dass ein Minimum des Betragsfrequenzgangs eines jeweiligen Filterelementes innerhalb eines anderen Frequenzintervalls liegt, als ein jeweiliges Minimum des Betragsfrequenzgangs der übrigen Filterelemente. Dabei weisen die Frequenzintervalle jeweils eine Harmonische der Schaltfrequenz als Mittelfrequenz und eine der Schaltfrequenz entsprechende Intervalllänge auf.

Die Druckschrift US 5,243,308 offenbart ein elektromagnetisches Rauschfilter mit mehreren U-förmigen Drähten, die durch Durchgangslöcher eines Ferritkerns verlaufen. Dabei wird jedes der Durchgangslöcher des Ferritkerns von jeweils einem oder von mehreren der U-förmigen Drähte durchsetzt. Die Drähte können miteinander verbunden werden, um eine Induktivität des Rauschfilters bereitzustellen.

Die Druckschrift US 2016 / 0172310 A1 offenbart eine integrierte Laminatstruktur zur Verwendung in einem elektronischen Gerät, mit mehreren modularen Laminatstrukturen. Die mehreren modularen Laminatstrukturen umfassen zwei oder mehr aus einer modularen induktiven Laminatstruktur, einer modulare kapazitiven Laminatstruktur, einer modularen Halbleiterchiplaminatstruktur und einer modularen elektromagnetischen Abschirmlaminatstruktur. Die mehreren modularen Laminatstrukturen können vertikal zusammenlaminiert sein.

Die Druckschrift US 4,777,465 offenbart einen auf einem Keramiksubstrat montierten quadratischen Toroid-Transformator. Primär- und Sekundärwicklung des Transformators werden durch eine erste Gruppe und eine zweite Gruppe von beabstandeten, parallel zueinander auf der Oberfläche des Keramiksubstrats verlaufenden Metallleitern gebildet. Über den Metallleitern ist eine Isolationsschicht so angeordnet, dass die jeweiligen Endabschnitte der Metallleiter freigelegt bleiben. Ein quadratischer Toroid-Ferritkern auf der Isolierschicht angeordnet. Drahtverbindungen verlaufen in Ebenen senkrecht zu Längsachsen gegenüberliegender Schenkel des Toroid-Ferritkerns und sind jeweils mit einem inneren Ende eines der Metallleiter und einem äußeren Ende eines benachbarten der Metallleiters verbunden.

Die Druckschrift US 2013 0285763 A1 offenbart einen Hybridkoppler für Hochfrequenz-Signale mit zwei induktiven Elementen und zwei kapazitiven Elementen.

### AUFGABE DER ERFINDUNG

Der Erfindung liegt die Aufgabe zugrunde, eine LC-Filteranordnung gemäß dem Oberbegriff des unabhängigen Patentanspruchs 1 aufzuzeigen, die in ihrer Herstellung gut reproduzierbare Filtereigenschaften aufweist. Dabei soll die LC-Filteranordnung eine Anpassung der Filterwirkung auch in einem relativ späten Stadium ihrer Herstellung erlauben. Gleichzeitig soll die LC-Filteranordnung einen möglichst geringen Bauraum beanspruchen und besonders kostengünstig herstellbar sein. Es ist weiterhin Aufgabe der Erfindung, ein elektrisches oder elektronisches Gerät mit einer derartigen LC-Filteranordnung bereitzustellen.

### LÖSUNG

Die Aufgabe der Erfindung wird durch eine LC-Filteranordnung mit den Merkmalen des unabhängigen Patentanspruchs 1 gelöst. Die abhängigen Patentansprüche 2 bis 14 sind auf bevorzugte Ausführungsformen der LC-Filteranordnung gerichtet. Der Patentanspruch 15 zielt auf ein elektrisches oder elektronisches Gerät mit einer erfindungsgemäßen LC-Filteranordnung.

### BESCHREIBUNG DER ERFINDUNG

Eine erfindungsgemäße LC-Filteranordnung beinhaltet eine Leiterbahnen aufweisende Leiterplatte und umfasst
- einen Eingang mit einem ersten und einem zweiten Eingangsanschluss,
- einen Ausgang mit einem ersten und einem zweiten Ausgangsanschluss,
- einen Filterkondensator, der den ersten Ausgangsanschluss mit dem zweiten Ausgangsanschluss verbindet,
- einen Magnetkern, und
- eine Drossel mit einer Mehrzahl von den Magnetkern umschließenden Windungen, sowie einem ersten und einem zweiten Drosselanschluss.

Dabei ist jede der Windungen mittels eines separaten, den Magnetkern zumindest teilweise umgebenden Leitersegments mit jeweils einem ersten und einem zweiten Ende gebildet. In einem mit der Leiterplatte montierten Zustand der LC-Filteranordnung ist das erste und das zweite Ende jeweils elektrisch an eine Leiterbahn der Leiterplatte angebunden. Jedes der Leitersegmente ist in einer Halterung angeordnet, die ein elektrisch isolierendes Material aufweist und ausgelegt ist, die Leitersegmente in vordefinierter Lage relativ zueinander zu positionieren und gegenüber dem Magnetkern elektrisch zu isolieren. Dabei ist die Halterung zusammen mit den darin fixierten Leitersegmenten zur Anordnung auf dem Magnetkern ausgelegt. Weiterhin ist das zweite Ende eines Leitersegmentes mit dem ersten Ende eines benachbarten Leitersegmentes elektrisch verbunden. Der erste Drosselanschluss wird durch ein verbleibendes erstes Ende eines außenliegenden Leitersegmentes gebildet, während der zweite Drosselanschluss durch ein verbleibendes zweites Ende eines weiteren außenliegenden Leitersegmentes gebildet wird. Dabei ist der erste Drosselanschluss mit dem ersten Eingangsanschluss und der zweite Drosselanschluss mit dem ersten Ausgangsanschluss der LC-Filteranordnung elektrisch verbunden. Die LC-Filteranordnung ist dadurch gekennzeichnet, dass die elektrischen Verbindungen der Leitersegmente miteinander - zumindest in einem Zustand, bei dem die LC-Filteranordnung mit der Leiterplatte montiert ist - zumindest einen Abgriff aufweisen, und wobei an den zumindest einen Abgriff eine zusätzliche Impedanz angeschlossen ist.

Dabei kann der Filterkondensator einerseits unmittelbar, d.h. ohne Zwischenschaltung weiterer Impedanzen, den ersten und den zweiten Ausgangsanschluss miteinander verbinden. In diesem Fall ist der Filterkondensator mit einem seiner Kontakte unmittelbar an den Drosselausgang und damit an eine außenliegende Windung der Drossel angeschlossen. Es liegt jedoch auch im Rahmen der Erfindung, dass der Filterkondensator lediglich mittelbar, d.h. unter Zwischenschaltung weiterer in Reihe zum Filterkondensator geschalteter Impedanzen, wie beispielsweise eines Widerstandes, den ersten mit dem zweiten Ausgangsanschluss verbindet. Insbesondere kann der Filterkondensator mit einem seiner Kontakte auch an einem einer innenliegenden Windung der Drossel zugeordneten Abgriff angeschlossen sein.

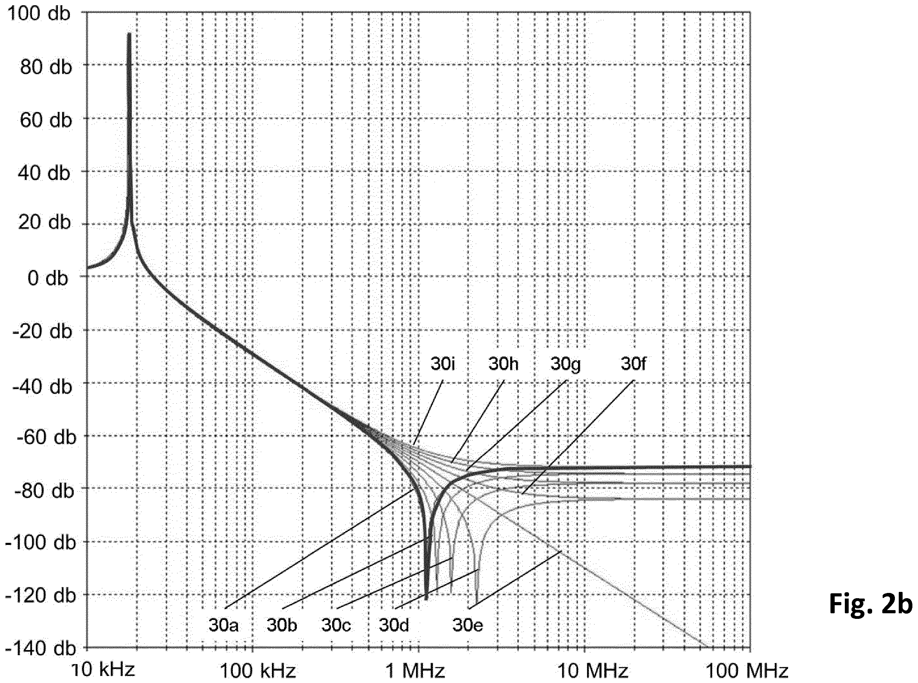

Indem die Halterung ausgelegt ist, die Leitersegmente in vordefinierter Lage relativ zueinander zu positionieren, ist eine hohe Reproduzierbarkeit in den Wicklungseigenschaften der Drossel und damit in den Filterparametern der LC-Filteranordnung gewährleistet. Gleichzeitig wird dadurch neben der hoch reproduzierbaren auch eine einfache und kostengünstige Herstellung der LC-Filteranordnung ermöglicht. Konkret kann eine Positionierung der Leitersegmente in der Halterung mit einem hohen Automatisierungsgrad - und damit mit großem Durchsatz - kostengünstig durchgeführt werden. Eine Montage der mit den Leitersegmenten versehenen Halterung mit der Leiterplatte, und somit eine Komplettierung der Drosselwicklung bzw. der Drosselwindungen wie auch eine Komplettierung der gesamten LC-Filteranordnung, kann ohne Schwierigkeiten in eine üblicherweise stark automatisierte Leiterplattenfertigung integriert werden. Dies gilt insbesondere auch für die elektrische Verbindung der Enden der Leitersegmente an die entsprechenden Leiterbahnen der Leiterplatte, die beispielsweise über einen ohnehin vorhandenen Lötprozess in der Leiterplattenfertigung erfolgen kann. Über die elektrische Verbindung der Enden der Leitersegmente kann ohne weiteres ein Abgriff, das heißt ein elektrischer Kontakt zu einzelnen Windungen bzw. deren Leitersegmenten hergestellt werden. Beispielsweise kann ein derartiger Abgriff bzw., können mehrere derartige Abgriffe unterschiedlicher Windungen über entsprechende Leiterbahnen von Anfang an auf der Leiterplatte vorgesehen werden. An den zumindest einen Abgriff kann die zumindest eine Impedanz elektrisch angeschlossen werden, über die dann die Filterwirkung gezielt beeinflusst und angepasst werden kann. Bei der Anpassung der Filterwirkung ist es von großer Bedeutung, dass die Windungen untereinander über den Magnetkern induktiv gekoppelt sind. Wie in Verbindung mit Fig. 2b gezeigt wird, kann so beispielsweise bei geeigneter Wahl der Impedanz und des zugeordneten Abgriffes eine Anpassung derart erfolgen, dass eine ansonsten prinzipbedingte stets vorhandene parasitäre Windungskapazität der Drossel signifikant reduziert, idealerweise sogar eliminiert wird. Eine Anpassung der Filterwirkung kann durch Vorhalten mehrerer Abgriffe an unterschiedlichen Windungen der Drossel auch noch in einem relativ späten Stadium erfolgen, bei dem ein grundlegendes Design der LC-Filteranordnung bereits feststeht. Beispielsweise können Abgriffe an allen Windungen vorgesehen werden, ohne dass jeder dieser Abgriffe zwingend zur Anbindung einer Impedanz genutzt werden muss.

In einer vorteilhaften Ausführungsform der LC-Filteranordnung weist die zusätzliche Impedanz zumindest eine der folgenden Baugruppen oder deren Kombination auf:
- einen Kondensator,
- eine Reihenschaltung aus einem Kondensator, einem Widerstand und optional einer Induktivität, und
- eine Parallelschaltung eines Kondensators und eines Widerstandes. Vorteilhafterweise ist dabei der zumindest eine Abgriff über die zusätzliche Impedanz mit dem zweiten Ausgangsanschluss verbunden.

In einer Ausführungsform der LC-Filteranordnung umfasst die Mehrzahl der Leitersegmente neben dem außenliegenden Leitersegment und dem weiteren außenliegenden Leitersegment zumindest ein innenliegendes Leitersegment, insbesondere mehrere innenliegende Leitersegmente. Somit weist die Drossel der Filteranordnung mehr als lediglich zwei (außenliegende) Windungen auf. In einem derartigen Fall können auch die elektrischen Verbindungen der Leitersegmente der LC-Filteranordnung eine Vielzahl von Abgriffen aufweisen, an die jeweils eine zusätzliche Impedanz angeschlossen ist. Insbesondere kann jede Verbindung zweier Leitersegmente der Drossel einen Abgriff aufweisen. Dabei können mehrere, optional jeder, dieser Abgriffe jeweils über eine zusätzliche Impedanz mit dem zweiten Ausgangsanschluss verbunden sein. In dieser Ausführungsform kann die elektrische Verbindung des zweiten Endes eines Leitersegmentes mit dem ersten Ende eines benachbarten Leitersegmentes für lediglich einige der innenliegenden benachbarten Leitersegmente, aber auch für jedes der innenliegenden benachbarten Leitersegmente vorliegen. Konkret können jeweils das erste Ende eines Leitersegmentes mit dem zweiten Ende eines jeweils vorangehenden Leitersegmentes, und das zweite Ende des Leitersegmentes mit dem ersten Ende eines jeweils nachfolgenden Leitersegmentes elektrisch verbunden sein.

In einer Ausführungsform der LC-Filteranordnung ist jeweils das zweite Ende eines Leitersegmentes und das erste Ende eines darauffolgenden, benachbarten Leitersegmentes elektrisch an dieselbe Leiterbahn angebunden, beispielsweise mit dieser verlötet. In diesem Fall wird die elektrische Verbindung benachbarter Leitersegmente über dieselbe Leiterbahn der Leiterplatte herbeigeführt, mit der auch die Enden benachbarter Leitersegmente elektrisch verbunden sind. Dabei kann jedes der Leitersegmente einen runden oder einen rechteckigen Querschnitt aufweisen. Vorteilhafterweise kann jedes der Leitersegmente einen gebogenen Bereich aufweisen, der einer U-Form mit zwei Schenkeln und einer der U-Form zugeordneten Basis entspricht. Mit einer derartigen U-Form ist das Leitersegment ausgelegt, den Magnetkern an drei Seiten seines Umfangs zu umgeben. Die Umschließung des Magnetkerns an der vierten Seite, und damit die Komplettierung der entsprechenden Windung, erfolgt über die Leiterbahn der Leiterplatte. Dabei können die Leitersegmente der Drossel über einen sogenannten Through-Hole-Technology (THT) - Prozess mit der Leiterbahn / den Leiterbahnen der Leiterplatte verbunden, insbesondere mit dieser verlötet sein. Im Rahmen des THT - Prozesses werden die an den Schenkeln der U-Form angeordneten Enden der Leitersegmente in entsprechende Bohrungen der Leiterplatte geführt. Die Leiterbahn kann dabei auf einer der Drossel abgewandten Rückseite der Leiterplatte oder aber - beispielsweise bei mehrschichtigen Leiterplatten - in einer mittleren Schicht der Leiterplatte angeordnet sein.

Alternativ zu der U-Form kann jedes der Leitersegmente auch eine ringförmige Biegung aufweisen und den Magnetkern an vier Seiten seines Umfangs - wenn auch nicht geschlossen
- umgeben. Die ringförmige Biegung kann gleichzeitig einen helixartigen Versatz aufweisen, so dass sich Stirnseiten benachbarter Leitersegmente gegenüberstehen. In diesem Fall bietet es sich an, die Leitersegmente der Drossel über einen sogenannten Surface Mount Device (SMD)
- Prozess mit der Leiterbahn / den Leiterbahnen der Leiterplatte zu verbinden, insbesondere zu verlöten. Bei dem SMD-Prozess sind die Leiterbahnen üblicherweise auf einer der Drossel zugewandten Seite der Leiterplatte oder - insbesondere bei mehrschichtigen Leiterplatten - in einer mittleren Schicht der Leiterplatte angeordnet. Alternativ können sich die Stirnseiten eines Leitersegments auch direkt gegenüberstehen, und die elektrische Verbindung benachbarter Leitersegmente wird durch eine entsprechend versetzt verlaufende Leiterbahn erreicht.

In einer Ausführungsform der LC-Filteranordnung ist der Magnetkern durch einen geschlossenen Magnetkern gebildet.

Dabei kann der Magnetkern einteilig aufgebaut sein, d.h. lediglich ein Kernsegment beinhalten. Alternativ dazu kann der Magnetkern jedoch auch aus mehreren Kernsegmenten zusammengesetzt sein. Der Magnetkern kann einen oder mehrere Spalte aufweisen. Alternativ dazu kann er aber auch spaltfrei aufgebaut sein. Der Magnetkern kann eine Ringform, insbesondere die Form eines Torus oder eines Rechtecks aufweisen.

In einer weiteren Ausführungsform der LC-Filteranordnung ist die Halterung ausgelegt, die Leitersegmente parallel zueinander zu führen. Dabei können die Leitersegmente einerseits über ihre gesamte Länge jeweils parallel zueinander geführt werden. Dies ist beispielsweise dann der Fall, wenn es sich bei dem Magnetkern um einen Magnetkern mit geraden, d.h. ungebogenen Magnetkernabschnitten handelt und die Halterung auf den geraden bzw. ungebogenen Magnetkernabschnitten angeordnet ist. Alternativ ist es jedoch auch möglich, dass die Halterung ausgelegt ist, die Leitersegmente lediglich über einen Bruchteil ihrer Länge parallel zueinander zu führen. Dies kann bei einem gebogenen, beispielsweise ringförmigen Magnetkern in Verbindung mit u-förmig oder ringförmig gebogenen Leitersegmenten der Fall sein. In einer derartigen Anordnung ist es möglich, dass lediglich zwei (am Innen- und am Außenumfang des Magnetkerns lokalisierte) Bereiche der Leitersegmente parallel zueinander geführt sind, während die restlichen Bereiche, beispielsweise eine Basis des U-förmig gebogenen Bereiches, nicht parallel zueinander ausgerichtet bzw. geführt sind.

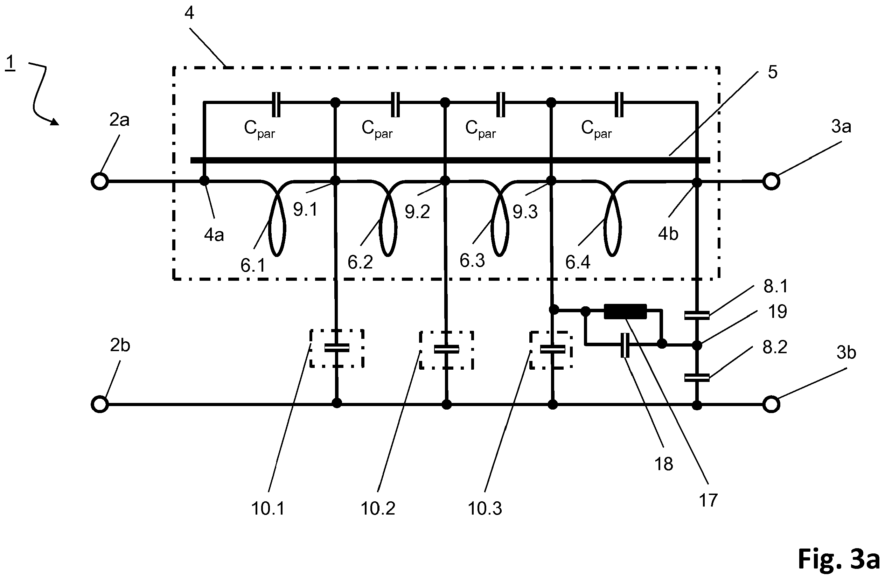

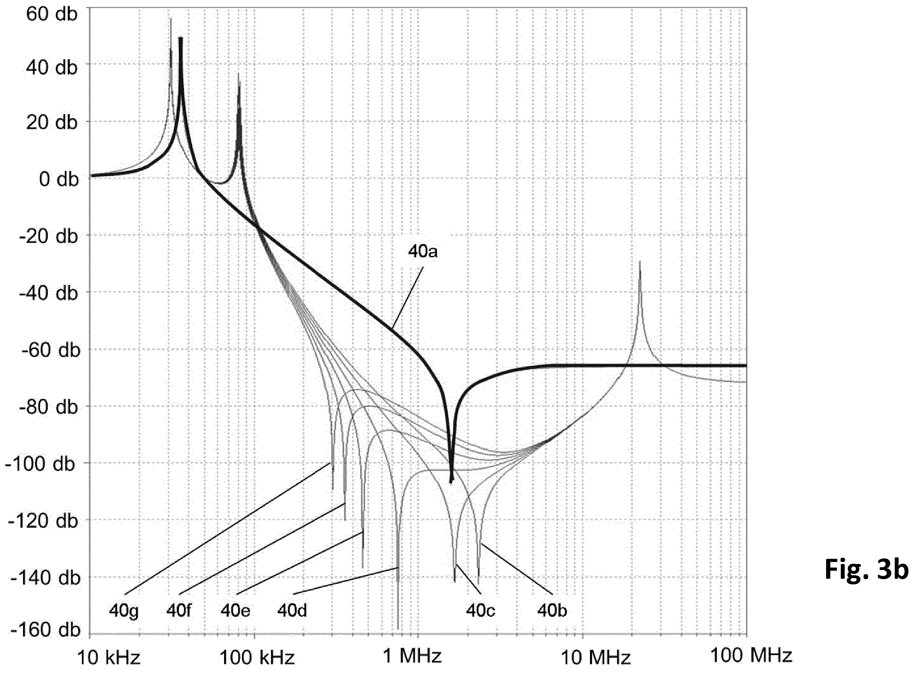

In einer Ausführungsform kann der Filterkondensator lediglich einen Filterkondensator aufweisen. Alternativ dazu ist es jedoch möglich, dass der Filterkondensator eine Reihenschaltung von mehreren, insbesondere von zwei Filterkondensatoren umfasst. In den letztgenannten Fällen kann zumindest einer der Abgriffe über eine weitere Induktivität oder über eine Parallelschaltung einer weiteren Induktivität und eines weiteren Kondensators mit einem Mittelabgriff der Reihenschaltung der Filterkondensatoren verbunden sein. Auf diese Weise ergibt sich, wie auch in Verbindung mit Fig. 3a und Fig. 3b gezeigt wird, eine weitere Option zur Feinabstimmung der LC-Filteranordnung.

In einer Ausführungsform weist die LC-Filteranordnung eine weitere, insbesondere zur Drossel baugleiche, den Magnetkern umschließende Drossel auf. Dabei ist die weitere Drossel mit ihrem ersten Drosselanschluss mit dem zweiten Eingangsanschluss und mit ihrem zweiten Drosselanschluss mit dem zweiten Ausgangsanschluss verbunden. Hierbei ist ein Kontakt des Filterkondensators mit einem innenliegenden, insbesondere einem mittig liegenden weiteren Abgriff der Drossel und ein anderer Kontakt des Filterkondensators mit einem innenliegenden, insbesondere einem mittig liegenden weiteren Abgriff der weiteren Drossel verbunden. Weiterhin ist der zumindest eine Abgriff der Drossel über die zusätzliche Impedanz mit dem korrespondierenden zumindest einen Abgriff der weiteren Drossel verbunden. Optional sind mehrere Abgriffe der Drossel jeweils über eine zusätzliche Impedanz mit entsprechenden korrespondierenden Abgriffen der weiteren Drossel verbunden. In einer ersten Variante der LC-Filteranordnung sind die Wicklungsrichtungen der Drossel und der weiteren Drossel relativ zueinander so orientiert, dass die LC-Filteranordnung hinsichtlich ihrer Filterfunktion als Gleichtakt-Drossel ausgelegt ist. In dieser Variante führt ein vom ersten Eingangsanschluss zum ersten Ausgangsanschluss fließender erster Strom in Verbindung mit einem vom zweiten Eingangsanschluss zum zweiten Ausgangsanschluss fließenden zweiten Strom, der im Gleichtakt zum ersten Strom fließt, zu einer konstruktiven Überlagerung der über die Ströme generierten magnetischen Flüsse. Entsprechend resultiert in dieser Variante eine Dämpfung eines Gleichtakt-Signals und die LC-Filteranordnung weist eine Filterwirkung ähnlich einer Gleichtakt-Drossel auf. Demgegenüber führt ein vom ersten Eingangsanschluss zum ersten Ausgangsanschluss fließender erster Strom in Verbindung mit einem vom zweiten Eingangsanschluss zum zweiten Ausgangsanschluss fließenden zweiten Strom, der im Gegentakt zum ersten Strom fließt, zu einer destruktiven Überlagerung der über die Ströme generierten magnetischen Flüsse. Gegentaktsignale werden daher in dieser Anordnung weniger bis kaum gedämpft. Alternativ zu der ersten Variante sind in einer zweiten Variante der Ausführungsform die Wicklungsrichtungen der Drossel und der weiteren Drossel relativ zueinander so orientiert, dass die LC-Filteranordnung hinsichtlich ihrer Filterfunktion als Gegentakt-Drossel ausgelegt ist. In der zweiten Variante führt ein vom ersten Eingangsanschluss zum ersten Ausgangsanschluss fließender erster Strom in Verbindung mit einem vom zweiten Eingangsanschluss zum zweiten Ausgangsanschluss fließenden zweiten Strom, der im Gegentakt zum ersten Strom fließt, zu einer konstruktiven Überlagerung der durch die Ströme generierten magnetischen Flüsse. Daraus resultiert eine Dämpfung der Gegentakt-Signale, während Gleichtakt-Signale weniger stark, bis kaum, gedämpft werden.

Ein erfindungsgemäßes elektrisches oder elektronisches Gerät umfasst eine erfindungsgemäße LC-Filteranordnung. Bei dem Gerät kann es sich um einen Wechselrichter, insbesondere um einen an ein Energieversorgungsnetz anschließbaren Photovoltaik (PV)-Wechselrichter zur Umwandlung von Gleichstrom in netzkonformen Wechselstrom handeln. Dabei kann die erfindungsgemäße LC-Filteranordnung zumindest einen Teil eines netzseitigen Ausgangsfilters des Wechselrichters ausbilden. Alternativ oder kumulativ dazu kann jedoch auch ein DCseitiger Eingangsfilter des Wechselrichters eine erfindungsgemäße LC-Filteranordnung aufweisen. Es ergeben sich die bereits im Zusammenhang mit der LC-Filteranordnung aufgeführten Vorteile.

### KURZBESCHREIBUNG DER FIGUREN

Im Folgenden wird die Erfindung anhand in den Figuren dargestellter bevorzugter Ausführungsbeispiele weiter erläutert und beschrieben. Davon zeigt
- Fig. 1a: eine explosionsartig dargestellte erfindungsgemäße LC-Filteranordnung und deren Anordnung auf einer Leiterplatte mit Leiterbahnen in einer ersten für einen THT Prozess ausgelegten Ausführungsform;
- **Fig. 1b**: eine für einen SMD - Prozess ausgelegten Drossel der erfindungsgemäßen LC-Filteranordnung in einer zweiten Ausführungsform;
- **Fig. 2a**: eine schematische Darstellung einer Topologie der erfindungsgemäßen LC-Filteranordnung in einer dritten Ausführungsform;
- **Fig. 2b**: Simulationsergebnisse zum Frequenzgang der LC-Filteranordnung gemäß Fig. 2a;
- **Fig. 3a**: eine schematische Darstellung einer Topologie der erfindungsgemäßen LC-Filteranordnung in einer vierten Ausführungsform; und
- **Fig. 3b**: Simulation zum Frequenzgang der LC-Filteranordnung gemäß Fig. 3a.

### FIGURENBESCHREIBUNG

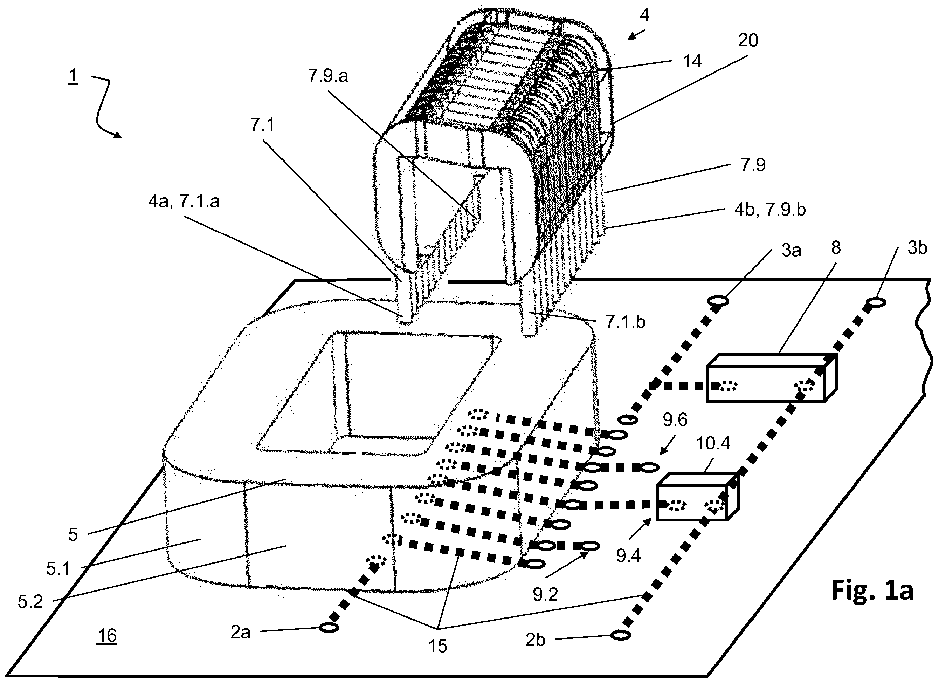

In **Fig. 1a** ist eine erste Ausführungsform der erfindungsgemäßen LC-Filteranordnung 1 und deren Anordnung auf einer Leiterplatte 16 in einer Explosionsdarstellung schematisch illustriert Die LC-Filteranordnung 1 umfasst eine Drossel 4, die in einem mit der Leiterplatte 16 montierten zustand mehrere (hier: exemplarisch 9) Windungen aufweist. Jede der Windungen umfasst ein U-förmig gebogenes Leitersegment 7.1-7.9. Die Leitersegmente 7.1-7.9 sind in einer Halterung 20 aus elektrisch isolierendem Material angeordnet. Dabei ist die Halterung 20 ausgelegt, die Leitersegmente 7.1-7.9 parallel zueinander zu führen und zu fixieren. Die Halterung 20 ist zusammen mit den darin fixierten Leitersegmenten 7.1-7.9 zur Anordnung auf einem Magnetkern 5 ausgelegt. Hierzu weist der Magnetkern 5 exemplarisch eine rechteckige Form mit gebogenen 5.1 und ungebogenen Magnetkernabschnitten 5.2 auf. Bei einer Montage der LC-Filteranordnung 1 werden erste Enden 7.1.a-7.9.a und zweite Enden 7.1.b-7.9.b der Leitersegmente 7.1-7.9 in entsprechende Bohrungen der Leiterplatte 16 eingeführt. Dabei sind die Bohrungen jeweils paarweise über auf einer Rückseite der Leiterplatte 16 angeordnete - und daher gestrichelt dargestellte - Leiterbahnen 15 miteinander verbunden. Über eine elektrische Verbindung (beispielsweise einer Verlötung) der Enden 7.1.a,b-7.9.a,b der Leitersegmente 7.1-7.9 mit den korrespondierenden Leiterbahnen 15 ergeben sich geschlossene Windungen der Drossel 4 um den Magnetkern 5. Ein außenliegendes erstes Ende 7.1.a der Drossel 4 ist über eine Leiterbahn 15 mit einem ersten Eingangsanschluss 2a der LC-Filteranordnung 1 elektrisch verbunden. Ein verbleibendes außenliegendes zweites Ende 7.9.b der Drossel 4 ist mit einem ersten Ausgangsanschluss 3a der LC-Filteranordnung 1 elektrisch verbunden. Ein zweiter Eingangsanschluss 2b ist über eine Leiterbahn 15 mit einem zweiten Ausgangsanschluss 3b verbunden. Auf der Leiterplatte 16 ist ein Filterkondensator 8 angeordnet, der den ersten Ausgangsanschluss 3a (hier: unmittelbar) mit dem zweiten Ausgangsanschluss 3b verbindet.

Die LC-Filteranordnung 1 weist mehrere Abgriffe 9.2, 9.4, 9.6 auf, die jeweils mit einer über eine Leiterbahn 15 herbeigeführte elektrische Verbindung zwischen zwei korrespondierenden Leitersegmenten 7.2 und 7.3, 7.4 und 7.5, sowie 7.6 und 7.7 verbunden sind. An einen der Abgriffe 9.2, 9.4, 9.6 (hier: 9.4) ist eine zusätzliche Impedanz 10.4 angeschlossen, die den Abgriff 9.4 mit dem zweiten Ausgangsanschluss 3b verbindet. Dabei weist die zusätzliche Impedanz 10.4 einen Kondensator auf, dessen Kapazität so gewählt ist, dass sie negative Effekte der durch die Windungen hervorgerufenen parasitären Kapazitäten auf die Filterwirkung der LC-Anordnung 1 zumindest reduziert. Auf diese Weise ergibt sich eine stärkere Dämpfung ungewünschter Störsignale der LC- Filteranordnung 1, insbesondere bei höheren Frequenzen.

Obwohl der Filterkondensator 8 in der illustrierten Ausführungsform die Ausgangsanschlüsse 3a, 3b unmittelbar und ohne Zwischenschaltung weiterer Impedanzen verbindet, ist im Rahmen der Erfindung jedoch auch eine mittelbare elektrische Verbindung der Ausgangsanschlüsse 3a, 3b über den Filterkondensator 8 möglich. Beispielsweise können weitere Impedanzen in Reihe mit dem Filterkondensator 8 geschaltet sein. Konkret kann der Filterkondensator 8 auch mit einem seiner Kontakte an einem innenliegenden Abgriff 9.2-9.8 der Drossel 4 angeschlossen sein, sofern dieser innenliegende Abgriff 9.2-9.8 verschieden von dem Abgriff 9.4 ist, an den die weitere Impedanz 10.4 angeschlossen ist.

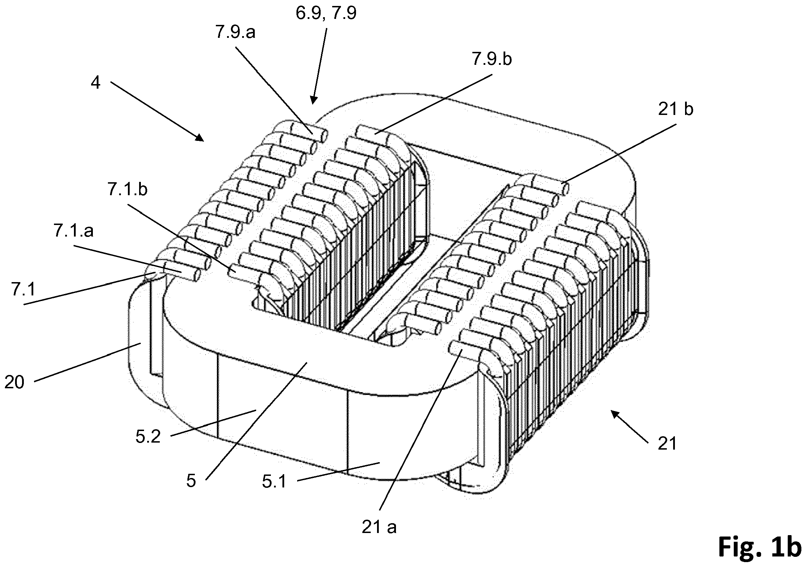

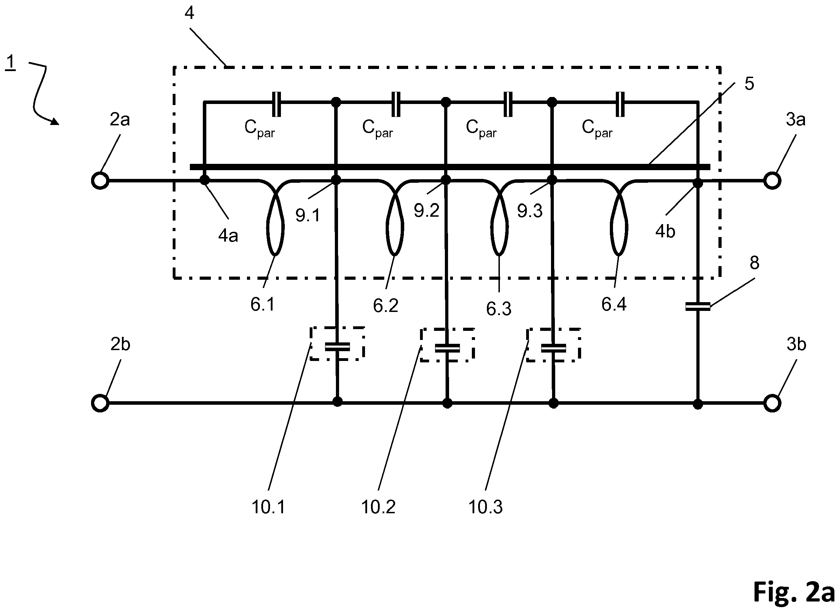

**Fig. 2** zeigt eine Detailansicht einer Drossel 4 und einer weiteren Drossel 21, die jeweils auf einem Magnetkern 5 einer zweiten Ausführungsform der LC-Filteranordnung 1 vormontiert sind. Die Leiterplatte 16 ist hier aus Gründen der Übersichtlichkeit nicht dargestellt. Die zweite Ausführungsform der LC-Filteranordnung 1 mit der Drossel 4 und der weiteren Drossel 21 ist in einem fertig montierten Zustand der LC-Filteranordnung 1 dazu eingerichtet, je nach Orientierung einer Wicklungsrichtung der Drossel 4 und der weiteren Drossel 21 in ihrer Filterwirkung als Gleichtaktdrossel oder als Gegentaktdrossel zu operieren. Während die Leitersegmente 7.1-7.9 in der Ausführungsform nach Fig. 1a U-förmig gebogen - und daher für eine Montage mit der Leiterplatte 16 mittels eines THT-Prozesses geeignet - sind, weisen die Leitersegmente 7.1-7.9 in der Ausführungsform nach Fig. 1b nun eine ringförmige Biegung auf. Dabei umschließt jedes der Leitersegmente 7.1-7.9 den Magnetkern 5 auf vier Seiten seines Umfangs - wenn auch nicht vollständig. Die Leitersegmente 7.1-7.9 weisen zusätzlich eine helixartig versetzte Biegung in axialer Richtung auf, die dazu führt, dass Enden benachbarter Leitersegmente 7.1-7.9 sich jeweils stirnseitig gegenüberstehen.

Eine derartige Anordnung der Leitersegmente 7.1-7.9 ist für eine Montage mit der Leiterplatte 16 mittels eines SMD-Prozesses geeignet. Bei dem SMD-Prozess wird die vormontierte Anordnung der Drossel 4, der weiteren Drossel 21 und des Magnetkerns 5 mit den sich gegenüberstehenden Enden 7.1.a,b - 7.9.a,b der Leitersegmente 7.1-7.9 auf entsprechenden Leiterbahnen 15 der Leiterplatte 16 positioniert. Dabei sind die Leiterbahnen 15 auf einer der Drossel 4 bzw. der weiteren Drossel 21 zugewandten Vorderseite der Leiterplatte 16 angeordnet und mit einem Lotmittel versehen. Während des SMD-Prozesses wird das Lotmittel verflüssigt und die den Magnetkern 5 vollständig umschließenden Windungen 6.1-6.9 der Drossel 4 und der weiteren Drossel 21 werden gebildet. Die elektrische Verbindung benachbarter Leitersegmente 7.1-7.9 untereinander wird hier, wie auch in der Ausführung nach Fig. 1b, über das Lotmittel und/oder die jeweiligen Leiterbahnen 15 herbeigeführt.

In **Fig. 2a** ist eine Topologie einer dritten Ausführungsform der erfindungsgemäßen LC-Filteranordnung 1 illustriert, die als Basis für eine Simulation der elektrischen Eigenschaften der LC-Filteranordnung 1, insbesondere deren Frequenzganges dient. Der erste Eingangsanschluss 2a der LC Filteranordnung 1 ist über eine Drossel 4, die einen ersten und einem zweiten Drosselanschluss 4b aufweist, mit dem ersten Ausgangsanschluss 3a verbunden. Der erste Ausgangsanschluss 3a ist über einen Filterkondensator 8 mit dem zweiten Ausgangsanschluss 3b verbunden. Weiterhin ist der zweite Eingangsanschluss 2b mit dem zweiten Ausgangsanschluss 3b elektrisch verbunden.

In dem exemplarisch dargestellten Ausführungsbeispiel weist die Drossel 4 vier Windungen 6.1-6.4 auf. Die Windungen 6.1-6.4 sind untereinander über den Magnetkern 5, auf dem die Drossel 4 angeordnet ist, induktiv gekoppelt. Parallel zu den Windungen 6.1-6.4 sind jeweils korrespondierende, prinzipbedingt stets vorhandene, parasitäre Kapazitäten Cₚₐᵣ der Drossel 4 eingezeichnet. Die parasitären Kapazitäten Cₚₐᵣ führen bei herkömmlichen LC-Filtern dazu, dass hochfrequente Signale zwischen den Eingangsanschlüssen 2a, 2b nur unzureichend gedämpft werden und somit noch in unerwünschter Höhe an den Ausgangsanschlüssen 3a, 3b vorhanden sind.

Zur Feinabstimmung der LC-Filteranordnung, beispielsweise im Hinblick auf eine Unterdrückung der parasitären Kapazitäten C_{Par} und der damit verbundenen Effekte, weist die LC-Filteranordnung 1 Abgriffe 9.1-9.3 zu jeder elektrischen Verbindung aufeinanderfolgender Windungen 6.1-6.4 auf. An die Abgriffe 9.1-9.3 sind Impedanzen 10.1-10.3 - hier exemplarisch jeweils in Form eines Kondensators - angeschlossen, die jeden der Abgriffe 9.1-9.3 mit dem zweiten Ausgangsanschluss 3b verbinden. Über eine geeignete Wahl der Impedanzen 10.1-10.3 lässt sich eine Optimierung und/oder eine Feinabstimmung der LC-Filteranordnung 1 durchführen.

In **Fig. 2b** sind Simulationsergebnisse für einen Frequenzgang der LC-Filteranordnung aus Fig. 2a für verschiedene Kapazitätswerte als Impedanzen 10.1-10.3 dargestellt. Bei der Simulation wurden die Kapazitäten des der ersten 10.1 und der dritten Impedanz 10.3 zugeordneten Kondensators als vernachlässigbar klein gewählt. Lediglich die Kapazität des der zweiten Impedanz 10.2 zugeordneten Kondensators wurde in mehreren diskreten Schritten zwischen einem Minimal- und einem Maximalwert variiert.

Bei einem kleinen Kapazitätswert des an dem zweiten Abgriff 9.2 angebundenen Kondensators entspricht der Frequenzgang noch dem typischen Frequenzgang eines realen LC-Tiefpass-Gliedes, der in Fig. 2b durch den fett gezeichneten Kurvenverlauf 30a illustriert ist. Dabei kennzeichnet die Resonanzüberhöhung bei niedrigen Frequenzen eine voreingestellte Resonanzfrequenz der LC-Filteranordnung, die sich aus der Induktivität der Drossel 4 und der Kapazität des Filterkondensators 8 ergibt. Bei höheren Frequenzen ergibt sich eine Resonanzerniedrigung, da dort eine zweite Resonanzbedingung im Hinblick auf die Induktivität der Drossel 4 und deren parasitäre Kapazität C_{Par} erfüllt ist. Danach ist keine zusätzliche Dämpfung eines Eingangssignales mehr vorhanden. Vielmehr verläuft der Frequenzgang parallel zur Abszisse.

Mit zunehmender Kapazität des an dem zweiten Abgriff 9.2 angeschlossenen Kondensators ergibt sich zunächst eine Verschiebung der Resonanzerniedrigung zu höheren Frequenzen. Dies ist in Fig. 2b durch die Kurvenverläufe 30b, 30c und 30d illustriert. Bei einem bestimmten Kapazitätswert des der zweiten Impedanz 10.2 zugeordneten Kondensators ergibt sich eine nahezu vollständige Kompensation der parasitären Kapazitäten C_{Par} der Drossel 4. In diesem Fall weist die LC-Filteranordnung 1 auch bei höheren Frequenzen eine zunehmende Dämpfung auf, was in Fig. 2b durch den Kurvenverlauf 30e illustriert ist. Mit weiter zunehmendem Kapazitätswert des an den zweiten Abgriff 9.2 angeschlossenen Kondensators nimmt die Dämpfung bei hohen Frequenzen wieder ab und nähert sich dort dem anfänglich diskutierten Kurvenverlauf 30a, nun allerdings ohne Resonanzerniedrigung. Dies ist in Fig. 2b durch die Kurvenverläufe 30f, 30g, 30h und 30i dargestellt.

Das gewählte Design der LC-Filteranordnung 1, beispielsweise die Wahl der Impedanzen 10.1-10.3 als Kondensatoren, wie auch die Anzahl der Windungen 6.1-6.3 der Drossel 4 in dieser Simulation ist rein exemplarisch. Weitergehende Simulationen zeigen, dass der durch den Kurvenverlauf 30e illustrierte Frequenzgang - zumindest näherungsweise - auch über eine andere Wahl von Impedanzen 10.1-10.3 realisiert werden kann.

Ein wesentlicher Vorteil der LC-Filteranordnung 1 ist, dass über die Halterung 20 eine gute Führung der Leitersegmente 7.1-7.9 relativ zueinander und daraus resultierend eine bestimmte Geometrie der Drossel 4 in hohem Maße reproduzierbar vorgegeben ist. Ein bestimmter Typ der Drossel 4, und damit einhergehend auch bestimmte vordefinierte Filtereigenschaften der LC-Filteranordnung 1, lassen sich sehr gut reproduzieren und weisen eine lediglich minimale Streuung auf. Die Reproduzierbarkeit der Filtereigenschaften der erfindungsgemäßen LC-Filteranordnung 1 ist signifikant stärker, als dies bei herkömmlichen LC-Filteranordnungen mit oftmals manuell gewickelten Drosseln 4 der Fall ist. Über die Abgriffe 9.1-9.3 und eine geeignete Wahl der an diese angeschlossenen Impedanzen 10.1-10.3 lassen sich unerwünschte Effekte in einem Frequenzgang der LC-Filteranordnung 1 auch in einem späten Stadium der Herstellung noch weitgehend reduzieren. Auch geringe, weiterhin bestehende Abweichungen zwischen unterschiedlichen LC-Filteranordnungen 1 gleichen Typs lassen sich durch gezielte Addition und/oder Änderung von Impedanzen 10.1-10.3 an entsprechenden Abgriffen 9.1-9.3 auf einfache Weise angleichen. Dabei ist die hohe Reproduzierbarkeit der Filtereigenschaften in besonders vorteilhafter Weise mit einer vergleichsweise einfachen Herstellung der LC-Filteranordnung 1 verknüpft. Dies gilt in gleicher Weise auch für die in Fig. 3a gezeigte Anordnung der LC-Filteranordnung 1.

In **Fig. 3a** ist eine Topologie der erfindungsgemäßen LC-Filteranordnung 1 in einer vierten Ausführungsform dargestellt. Die Topologie ähnelt weitgehend der bereits in Fig. 2a dargestellten Ausführungsform der LC-Filteranordnung 1, weswegen hinsichtlich der übereinstimmenden Aspekte auf die Beschreibungen unter Figur 2a verwiesen wird. Im Unterschied zu der in Figur 2a dargestellten Variante weist der Filterkondensator 8 der LC-Filteranordnung 1 gemäß Figur 3a nun jedoch eine Reihenschaltung zweier Filterkondensatoren 8.1, 8.2 auf. Ein Mittelabgriff 19 der Reihenschaltung beider Filterkondensatoren 8.1, 8.2 ist über eine Parallelschaltung einer weiteren Induktivität 17 und eines weiteren Kondensators 18 mit dem dritten Abgriff 9.3 der LC-Filteranordnung 1 verbunden.

In **Fig. 3b** sind Simulationsergebnisse der LC-Filteranordnung 1 entsprechend gemäß der in Fig. 3a dargestellten Topologie in Form verschiedener Kurvenverläufe 30a-30g illustriert. Jeder der Kurvenverläufe gibt dabei jeweils einen Frequenzgang einer Simulation in Abhängigkeit der Frequenz wieder. Bei der Simulationen wurden die erste Impedanzen 10.1 und die dritte Impedanz 10.3 entsprechend der in Figur 2a diskutierten Anordnung gewählt. Für die zweite Impedanz 10.2 wurde ein Kondensator mit einem Kapazitätswert gewählt, der dem des Kurvenverlaufs 30e aus Fig. 2b entspricht. Während der Simulation wurden die erste 10.1, die zweite Impedanz 10.2, die dritte Impedanz 10.3, wie auch der Wert der weiteren Induktivität 18 konstant gehalten. Demgegenüber wurde die Kapazität des weiteren Kondensators 18 zwischen einem Minimalwert und einem Maximalwert in 6 diskreten Schritten variiert. Mit steigender Kapazität des weiteren Kondensators 18 ergeben sich somit die Frequenzgänge gemäß der Illustrierten Kurvenverläufe 40b-40g. Der Kurvenverlauf 40a stellt zum Vergleich nochmals den Frequenzgang einer LC-Filteranordnung 1 dar, die frei von an die Abgriffe 9.1-9.3 angebundenen Impedanzen 10.1-10.3, frei von einer weiteren Induktivität 17 und frei von einem weiteren Kondensator 18 ist.

Ziel dieser Simulation ist es, die LC-Filteranordnung 1 in einem Frequenzbereich von 100 kHz bis 1500 kHz mit möglichst hoher Dämpfung auszulegen. Je nach Vorgabe eines einzuhaltenden Grenzwertverlaufes kann hier einer der Kurvenverläufe 40b-40g, bzw. ein diesem Kurvenverlauf 40b-40g zugeordneter Kapazitätswert des weiteren Kondensators 18 ausgewählt werden, um die gewünschte Dämpfung zu realisieren. Auch in diesem Fall ist die sehr gute Reproduzierbarkeit in der Herstellung der LC-Filteranordnung 1 von Vorteil, um die Streuung der Filtereigenschaften von LC-Filteranordnungen 1 mit einem bestimmten Drosseltyp zu minimieren.

**BEZUGSZEICHENLISTE**

| | | |
|---|---|---|
| 1 | | LC-Filteranordnung |
| 2a, 2b | | Eingangsanschluss |
| 3a, 3b | | Ausgangsanschluss |
| 4 | | Drossel |
| 4a, 4b | | Drosselanschluss |
| 5 | | Magnetkern |
| 5.1 | | Magnetkernabschnitt |
| 5.2 | | Magnetkernabschnitt |
| 6.1 - 6.n | | Windung |
| 7.1 - 7.n | | Leitersegment |
| 7.1.a - 7.n.a | | Ende |
| 7.1.b - 7.n.b | | Ende |
| 8, 8.1, 8.2 | | Filterkondensator |
| 9.1 - 9.n-1 | | Abgriff |
| 10.1 - 10.n-1 | | Impedanz |
| 11.1 - 1 1.n-1 | | Kondensator |
| 12.1 - 12.n-1 | | Widerstand |
| 13.1 - 13.n-1 | | Induktivität |
| 14 | | Bereich |
| 15 | | Leiterbahn |
| 16 | | Leiterplatte |
| 17 | | Induktivität |
| 18 | | Kondensator |
| 19 | | Mittel abgriff |
| 20 | | Halterung |
| 21 | | Drossel |
| 30a-30i | | Kurvenverlauf |
| 40a-40f | | Kurvenverlauf |
| | | |
| | | |

## Patentansprüche

1. LC-Filteranordnung (1) mit einer Leiterbahnen (15) aufweisenden Leiterplatte (16), umfassend:
- einen Eingang mit einem ersten Eingangsanschluss (2a) und einem zweiten Eingangsanschluss (2b),
- einen Ausgang mit einem ersten Ausgangsanschluss (3a) und einem zweiten Ausgangsanschluss (3b),
- einem Filterkondensator (8) der den ersten Ausgangsanschluss (3a) mit dem zweiten Ausgangsanschluss (3b) verbindet,
- einen Magnetkern (5),
- eine Drossel (4) mit einer Mehrzahl von den Magnetkern (5) umschließenden Windungen (6.1 - 6.n) und einem ersten Drosselanschluss (4a) und einem zweiten Drosselanschluss (4b),
o wobei jede der Windungen (6.1 - 6.n) mittels eines separaten, den Magnetkern (5) zumindest teilweise umgebenden Leitersegments (7.1 - 7.n) mit jeweils einem ersten (7.1.a - 7.n.a) und einem zweiten Ende (7.1.b - 7.n.b) gebildet ist,
o wobei in einem mit der Leiterplatte (16) montierten Zustand der LC-Filteranordnung (1) das erste (7.1.a - 7.n.a) und das zweite Ende (7.1.b - 7.n.b) jeweils elektrisch an eine Leiterbahn (15) der Leiterplatte (16) angebunden ist,
o wobei jedes der Leitersegmente (7.1 - 7.n) in einer Halterung (20) angeordnet ist, die ein elektrisch isolierendes Material aufweist und ausgelegt ist, die Leitersegmente (7.1 - 7.n) in vordefinierter Lage relativ zueinander zu positionieren und gegenüber dem Magnetkern (5) elektrisch zu isolieren,
o wobei die Halterung (20) zusammen mit den darin fixierten Leitersegmenten (7.1 - 7.n) zur Anordnung auf dem Magnetkern (5) ausgelegt ist,
o wobei das zweite Ende (7.1.b - 7.n-1.b) eines Leitersegmentes (7.1 - 7.n-1) mit dem ersten Ende (7.2.a - 7.n.a) eines benachbarten Leitersegmentes (7.2 - 7.n) elektrisch verbunden ist, und
o wobei der erste Drosselanschluss (4a) durch ein verbleibendes erstes Ende (7.1.a) eines außenliegenden Leitersegmentes (7.1) und der zweite Drosselanschluss (4b) durch ein verbleibendes zweites Ende (7.n.b) eines weiteren außenliegenden Leitersegmentes (7.n) gebildet wird,
- wobei der erste Drosselanschluss (4a) mit dem ersten Eingangsanschluss (2a) und der zweite Drosselanschluss (4b) mit dem ersten Ausgangsanschluss (3a) elektrisch verbunden ist,
**dadurch gekennzeichnet, dass**
die elektrischen Verbindungen der Leitersegmente (7.1 - 7.n) miteinander zumindest einen Abgriff (9.1 - 9.n-1) aufweisen, wobei an den zumindest einen Abgriff (9.1 - 9.n-1) eine zusätzliche Impedanz (10.1 - 10.n-1) angeschlossen ist.

2. LC-Filteranordnung (1) nach Anspruch 1, **dadurch gekennzeichnet, dass** die zusätzliche Impedanz (10.1 -10.n-1) zumindest eine der folgenden Baugruppen oder deren Kombination umfasst:
- einen Kondensator (11.1 - 11.n),
- eine Reihenschaltung aus einem Kondensator (11.1 - 11.n-1), einem Widerstand (12.1 - 12.n-1) und optional einer Induktivität (13.1 - 13.n-1), und
- eine Parallelschaltung eines Kondensators (11.1 - 11.n-1) und eines Widerstandes (12.1 - 12.n-1).

3. LC-Filteranordnung (1) nach einem der vorangehenden Ansprüche, **dadurch gekennzeichnet, dass** die Mehrzahl der Leitersegmente (7.1 - 7.n) neben dem außenliegenden Leitersegment (7.1) und dem weiteren außenliegenden Leitersegment (7.n) ein innenliegendes Leitersegment (7.2), insbesondere mehrere innenliegende Leitersegmente (7.2 - 7.n-1) umfasst.

4. LC-Filteranordnung (1) nach Anspruch 3, **dadurch gekennzeichnet, dass** die elektrischen Verbindungen der Leitersegmente (7.1 - 7.n) der LC-Filteranordnung (1) eine Vielzahl von Abgriffen (9.1 - 9.n-1) aufweisen, an die jeweils eine zusätzliche Impedanz (10.1 - 10.n-1) angeschlossen ist.

5. LC-Filteranordnung (1) nach einem der vorangehenden Ansprüche, **dadurch gekennzeichnet, dass** der zumindest eine Abgriff (9.1 - 9.n-1) über die zusätzliche Impedanz (10.1 - 10.n-1) mit dem zweiten Ausgangsanschluss (3b) verbunden ist.

6. LC-Filteranordnung (1) nach einem der vorangehenden Ansprüche, **dadurch gekennzeichnet, dass** die Halterung (20) ausgelegt ist, die Leitersegmente (7.1 - 7.n) parallel zueinander zu führen.

7. LC-Filteranordnung (1) nach einem der vorangehenden Ansprüche, **dadurch gekennzeichnet, dass** jedes der Leitersegmente (7.1 - 7.n) einen runden oder rechteckigen Querschnitt aufweist.

8. LC-Filteranordnung (1) nach einem der vorangehenden Ansprüche, **dadurch gekennzeichnet, dass** jedes der Leitersegmente (7.1 - 7.n) einen gebogenen Bereich (14) aufweist, der einer U-Form entspricht, und wobei optional jedes der Leitersegmente (7.1 - 7.n) ringförmig gebogen ist, so, dass sich Stirnseiten benachbarter Leitersegmente (7.1 - 7.n) gegenüberstehen.

9. LC-Filteranordnung (1) nach einem der vorangehenden Ansprüche, **dadurch gekennzeichnet, dass** das zweite Ende (7.1.b - 7.n-1.b) eines Leitersegmentes (7.1 - 7.n-1) und das erste Ende (7.2.a - 7.n.a) eines benachbarten Leitersegmentes (7.2 - 7.n) elektrisch an dieselbe Leiterbahn (15) angebunden sind, so dass eine elektrische Verbindung benachbarter Leitersegmente (7.1 - 7.n) über die Leiterbahn (15) der Leiterplatte (16) herbeigeführt wird, wobei zudem optional die Leitersegmente (7.1 - 7.n) der Drossel (4) über einen THT (Through-Hole-Technology) - Prozess oder über einen SMD (Surface Mount Device) - Prozess mit der Leiterplatte verbunden sind.

10. LC-Filteranordnung (1) nach einem der vorangehenden Ansprüche, **dadurch gekennzeichnet, dass** der Magnetkern (5) durch einen geschlossenen Magnetkern (5) gebildet ist, und insbesondere eine Form eines Torus oder eines Rechtecks aufweist.

11. LC-Filteranordnung (1) nach einem der vorangehenden Ansprüche, **dadurch gekennzeichnet, dass** der Filterkondensator (8) über eine Reihenschaltung von zwei Filterkondensatoren (8.1, 8.2) gebildet ist.

12. LC-Filteranordnung (1) nach Anspruch 11, **dadurch gekennzeichnet, dass** zumindest einer der Abgriffe (9.1 - 9.2) über eine weitere Induktivität (17) oder über eine Parallelschaltung einer weiteren Induktivität (17) und eines weiteren Kondensators (18) mit einem Mittelabgriff (19) der Reihenschaltung der Filterkondensatoren (8.1, 8.2) verbunden ist.

13. LC-Filteranordnung (1) nach einem der Ansprüche 1 bis 11, **dadurch gekennzeichnet, dass**
- die LC-Filteranordnung (1) eine weitere, zur Drossel (4) baugleiche, den Magnetkern (5) umschließende Drossel (21) aufweist, die mit ihrem ersten Drosselanschluss (21a) mit dem zweiten Eingangsanschluss (2b) und mit ihrem zweiten Drosselanschluss (21b) mit dem zweiten Ausgangsanschluss (3b) verbunden ist,
- wobei ein Kontakt des Filterkondensators (8) mit einem innenliegenden, insbesondere einem mittig liegenden weiteren Abgriff (9.n/2) der Drossel (4) und ein anderer Kontakt des Filterkondensators (8) mit einem innenliegenden, insbesondere einem mittig liegenden weiteren Abgriff (9.n/2) der weiteren Drossel (21) verbunden ist, und
- wobei der zumindest eine Abgriff (9.1 - 9.n-1) der Drossel (4) über die zusätzliche Impedanz (10.1-10.n-1) mit dem korrespondierenden zumindest einen Abgriff (9.1 - 9.n-1) der weiteren Drossel (21) verbunden ist.

14. LC-Filteranordnung (1) nach Anspruch 13, **dadurch gekennzeichnet, dass** die Wicklungsrichtungen der Drossel (4) und der weiteren Drossel (21) relativ zueinander so orientiert sind, dass die LC-Filteranordnung (1) hinsichtlich ihrer Filterfunktion als Gleichtakt-Drossel ausgelegt oder dass die Wicklungsrichtungen der Drossel (4) und der weiteren Drossel (21) relativ zueinander so orientiert sind, dass die LC-Filteranordnung (1) hinsichtlich ihrer Filterfunktion als Gegentakt-Drossel ausgelegt ist.

15. Elektrisches oder elektronisches Gerät, insbesondere ein Wechselrichter, mit einer LC-Filteranordnung (1) nach einem der vorangehenden Ansprüche.

## Claims

1. An LC filter arrangement (1) with a printed circuit board (16) having conductor tracks (15), comprising:
- an input having a first input terminal (2a) and a second input terminal (2b),
- an output having a first output terminal (3a) and a second output terminal (3b)
- a filter capacitor (8) connecting the first output terminal (3a) with the second output terminal (3b)
- a magnetic core (5),
- a choke (4) comprising a plurality of windings (6.1 - 6.n) surrounding the magnetic core (5) and a first choke terminal (4a) and a second choke terminal (4b),
∘ wherein each of the windings (6.1 - 6.n) is formed by means of a separate conductor segment (7.1 - 7.n) at least partially surrounding the magnetic core (5), each conductor segment having a first end (7.1.a - 7.n.a) and a second end (7.1.b - 7.n.b),
∘ wherein in a state of the LC filter arrangement (1) mounted with the printed circuit board (16), the first (7.1.a - 7.n.a) and the second end (7.1.b - 7.n.b) are each electrically connected to a conductor track (15) of the printed circuit board (16),
∘ wherein each of the conductor segments (7.1 - 7.n) is arranged in a holder (20) comprising an electrically insulating material and adapted to position the conductor segments (7.1 - 7.n) in a predefined position relative to each other and to electrically insulate them with respect to the magnetic core (5),
∘ wherein the holder (20) in combination with the conductor segments (7.1 - 7.n) fixed therein is adapted to be arranged on the magnetic core (5),
∘ wherein the second end (7.1.b - 7.n-1.b) of a conductor segment (7.1 - 7.n-1) is electrically connected to the first end (7.2.a - 7.n.a) of an adjacent conductor segment (7.2 - 7.n), and
∘ wherein the first choke terminal (4a) is formed by a remaining first end (7.1.a) of an outer conductor segment (7.1) and the second choke terminal (4b) is formed by a remaining second end (7.n.b) of a further outer conductor segment (7.n),
- wherein the first choke terminal (4a) is electrically connected to the first input terminal (2a) and the second choke terminal (4b) is electrically connected to the first output terminal (3a),
**characterized in that**
the electrical connections of the conductor segments (7.1 - 7.n) to one another have at least one tap (9.1 - 9.n-1), wherein an additional impedance (10.1 - 10.n-1) is connected to the at least one tap (9.1 - 9.n-1).

2. The LC filter arrangement (1) according to claim 1, **characterized in that** the additional impedance (10.1 -10.n-1) comprises at least one of the following components or a combination thereof:
- a capacitor (11.1 - 11.n),
- a series circuit of a capacitor (11.1 - 11.n-1), a resistor (12.1 - 12.n-1) and optionally an inductor (13.1 - 13.n-1), and
- a parallel circuit of a capacitor (11.1 - 11.n-1) and a resistor (12.1 - 12.n-1).

3. The LC filter arrangement (1) according to one of the preceding claims, **characterized in that** the plurality of conductor segments (7.1 - 7.n) comprises, in addition to the outer conductor segment (7.1) and the further outer conductor segment (7.n), an inner conductor segment (7.2), in particular a plurality of inner conductor segments (7.2 - 7.n-1).

4. The LC filter arrangement (1) according to claim 3, **characterized in that** the electrical connections of the conductor segments (7.1 - 7.n) of the LC filter arrangement (1) comprise a plurality of taps (9.1 - 9.n-1) to each of which an additional impedance (10.1 - 10.n-1) is connected.

5. LC filter arrangement (1) according to one of the preceding claims, **characterized in that** the at least one tap (9.1 - 9.n-1) is connected to the second output terminal (3b) via the additional impedance (10.1 - 10.n-1).

6. The LC filter arrangement (1) according to one of the preceding claims, **characterized in that** the holder (20) is designed to guide the conductor segments (7.1 - 7.n) parallel to one another.

7. The LC filter arrangement (1) according to one of the preceding claims, **characterized in that** each of the conductor segments (7.1 - 7.n) has a round or rectangular cross section.

8. The LC filter arrangement (1) according to one of the preceding claims, **characterized in that** each of the conductor segments (7.1 - 7.n) comprises a bent region (14) corresponding to a U-shape, and wherein optionally each of the conductor segments (7.1 - 7.n) is bent in an annular shape such that end faces of adjacent conductor segments (7.1 - 7.n) are facing each other.

9. The LC filter arrangement (1) according to one of the preceding claims, **characterized in that** the second end (7.1.b - 7.n-1.b) of a conductor segment (7.1 - 7.n-1) and the first end (7.2.a - 7.n.a) of an adjacent conductor segment (7.2 - 7.n) are electrically connected to the same conductor track (15), so that an electrical connection of adjacent conductor segments (7. 1 - 7.n) is built up via the conductor track (15) of the printed circuit board (16), wherein, optionally in addition, the conductor segments (7.1 - 7.n) of the choke (4) are connected to the printed circuit board via a THT (through-hole technology) process or via an SMD (surface mount device) process.

10. The LC filter arrangement (1) according to one of the preceding claims, **characterized in that** the magnetic core (5) is formed by a closed magnetic core (5), and in particular comprises a shape of a torus or a rectangle.

11. The LC filter arrangement (1) according to one of the preceding claims, **characterized in that** the filter capacitor (8) is formed by a series circuit of two filter capacitors (8.1, 8.2).

12. The LC filter arrangement (1) according to claim 11, **characterized in that** at least one of the taps (9.1 - 9.2) is connected via a further inductance (17) or via a parallel circuit of a further inductance (17) and a further capacitor (18) to a center tap (19) of the series circuit of the filter capacitors (8.1, 8.2).

13. The LC filter arrangement (1) according to one of claims 1 to 11, **characterized in that**
- the LC filter arrangement (1) comprises a further choke (21), identical in construction to the choke (4), surrounding the magnetic core (5) and being connected by its first choke terminal (21a) to the second input terminal (2b) and by its second choke terminal (21b) to the second output terminal (3b),
- wherein one contact of the filter capacitor (8) is connected to an internal, in particular a centrally located further tap (9.n/2) of the choke (4) and another contact of the filter capacitor (8) is connected to an internal, in particular a centrally located further tap (9.n/2) of the further choke (21), and
- wherein the at least one tap (9.1 - 9.n-1) of the choke (4) is connected to the corresponding at least one tap (9.1 - 9.n-1) of the further choke (21) via the additional impedance (10.1-10.n-1).

14. The LC filter arrangement (1) according to claim 13, **characterized in that** the winding directions of the choke (4) and of the further choke (21) are oriented relative to one another in such a way that the LC filter arrangement (1) is designed as a common-mode choke with regard to its filter function, or **in that** the winding directions of the choke (4) and of the further choke (21) are oriented relative to one another in such a way that the LC filter arrangement (1) is designed as a differential-mode choke with regard to its filter function.

15. An electrical or electronic device, in particular an inverter, comprising the LC filter arrangement (1) according to any one of the preceding claims.

## Revendications

1. Dispositif de filtre LC (1) avec une carte imprimée (16) présentant des pistes conductrices (15), comprenant :
- une entrée avec une première borne d'entrée (2a) et une deuxième borne d'entrée (2b),
- une sortie avec une première borne de sortie (3a) et une deuxième borne de sortie (3b),
- un condensateur de filtrage (8) qui relie la première borne de sortie (3a) à la deuxième borne de sortie (3b),
- un noyau magnétique (5),
- une bobine d'arrêt (4) comprenant une pluralité de spires (6.1 - 6.n) entourant le noyau magnétique (5) et une première borne de bobine d'arrêt (4a) et une deuxième borne de bobine d'arrêt (4b),
∘ chacune des spires (6.1 - 6.n) étant formée au moyen d'un segment conducteur (7.1 - 7.n) séparé, entourant au moins partiellement le noyau magnétique (5) et comportant respectivement une première (7.1.a - 7.n.a) et une deuxième extrémité (7.1.b - 7.n.b),
∘ la première (7.1.a - 7.n.a) et la deuxième extrémité (7.1.b - 7.n.b) étant chacune reliée électriquement à une piste conductrice (15) de la carte imprimée (16) dans un état monté avec la carte imprimée (16) du dispositif de filtre LC (1),
∘ chacun des segments conducteurs (7.1 - 7.n) étant disposé dans un support (20) qui présente un matériau électriquement isolant et qui est conçu pour positionner les segments conducteurs (7.1 - 7.n) dans une position prédéfinie les uns par rapport aux autres et pour les isoler électriquement par rapport au noyau magnétique (5),
∘ le support (20) étant conçu, avec les segments conducteurs (7.1 - 7.n) qui y sont fixés, pour être disposé sur le noyau magnétique (5),
∘ la deuxième extrémité (7.1.b - 7.n-1.b) d'un segment conducteur (7.1 - 7.n-1) étant reliée électriquement à la première extrémité (7.2.a - 7.n.a) d'un segment conducteur adjacent (7.2 - 7.n), et
∘ la première borne de bobine d'arrêt (4a) étant formée par une première extrémité restante (7.1.a) d'un segment conducteur extérieur (7.1) et la deuxième borne de bobine d'arrêt (4b) étant formée par une deuxième extrémité restante (7.n.b) d'un autre segment conducteur extérieur (7.n),
- la première borne de bobine d'arrêt (4a) étant reliée électriquement à la première borne d'entrée (2a) et la deuxième borne de bobine d'arrêt (4b) à la première borne de sortie (3a),
**caractérisé en ce que**
les connexions électriques des segments conducteurs (7.1 - 7.n) présentent entre elles au moins une prise (9.1 - 9.n-1), une impédance supplémentaire (10.1 - 10.n-1) étant raccordée à la au moins une prise (9.1 - 9.n-1).

2. Dispositif de filtre LC (1) selon la revendication 1, **caractérisé en ce que** l'impédance supplémentaire (10.1 - 10.n-1) comprend au moins l'un des ensembles suivants ou leur combinaison :
- un condensateur (11.1 - 11.n),
- un montage en série d'un condensateur (11.1 - 11.n-1), d'une résistance (12.1 - 12.n-1) et éventuellement d'une inductance (13.1 - 13.n-1), et
- un montage en parallèle d'un condensateur (11.1 - 11.n-1) et d'une résistance (12.1 - 12.n-1).

3. Dispositif de filtre LC (1) selon l'une des revendications précédentes, **caractérisé en ce que** la pluralité de segments conducteurs (7.1 - 7.n) comprend, outre le segment conducteur extérieur (7.1) et l'autre segment conducteur extérieur (7.n), un segment conducteur intérieur (7.2), notamment plusieurs segments conducteurs intérieurs (7.2 - 7.n-1).

4. Dispositif de filtre LC (1) selon la revendication 3, **caractérisé en ce que** les connexions électriques des segments conducteurs (7.1 - 7.n) du dispositif de filtre LC (1) présentent une pluralité de prises (9.1 - 9.n-1) auxquelles est raccordée respectivement une impédance supplémentaire (10.1 - 10.n-1).

5. Dispositif de filtre LC (1) selon l'une des revendications précédentes, **caractérisé en ce que** l'au moins une prise (9.1 - 9.n-1) est reliée à la deuxième borne de sortie (3b) via l'impédance supplémentaire (10.1 - 10.n-1).

6. Dispositif de filtre LC (1) selon l'une des revendications précédentes, **caractérisé en ce que** le support (20) est conçu pour guider les segments conducteurs (7.1 - 7.n) parallèlement les uns aux autres.

7. Dispositif de filtre LC (1) selon l'une des revendications précédentes, **caractérisé en ce que** chacun des segments conducteurs (7.1 - 7.n) présente une section transversale ronde ou rectangulaire.

8. Dispositif de filtre LC (1) selon l'une des revendications précédentes, **caractérisé en ce que** chacun des segments conducteurs (7.1 - 7.n) présente une zone courbée (14) qui correspond à une forme en U, et dans lequel, en option, chacun des segments conducteurs (7.1 - 7.n) est courbé en forme d'anneau, de telle sorte que les faces frontales de segments conducteurs voisins (7.1 - 7.n) se font face.

9. Dispositif de filtre LC (1) selon l'une des revendications précédentes, **caractérisé en ce que** la deuxième extrémité (7.1.b - 7.n-1.b) d'un segment conducteur (7.1 - 7.n-1) et la première extrémité (7.2.a - 7.n.a) d'un segment conducteur voisin (7.2 - 7.n) sont reliées électriquement à la même piste conductrice (15), de sorte qu'une connexion électrique de segments conducteurs voisins (7.1 - 7.n-1.b) est possible. 1 - 7.n) par l'intermédiaire de la piste conductrice (15) de la carte imprimée (16), les segments conducteurs (7.1 - 7.n) de la bobine d'arrêt (4) étant en outre reliés à la carte imprimée par un processus THT (Through-Hole-Technology) ou par un processus SMD (Surface Mount Device).

10. Dispositif de filtre LC (1) selon l'une des revendications précédentes, **caractérisé en ce que** le noyau magnétique (5) est formé par un noyau magnétique fermé (5) et présente notamment une forme de tore ou de rectangle.

11. Dispositif de filtre LC (1) selon l'une des revendications précédentes, **caractérisé en ce que** le condensateur de filtrage (8) est formé par un montage en série de deux condensateurs de filtrage (8.1,8.2).

12. Dispositif de filtre LC (1) selon la revendication 11, **caractérisé en ce qu'**au moins l'une des prises (9.1 - 9.2) est reliée à une prise médiane (19) du circuit série des condensateurs de filtrage (8.1, 8.2) par l'intermédiaire d'une autre inductance (17) ou d'un circuit parallèle d'une autre inductance (17) et d'un autre condensateur (18).

13. Dispositif de filtre LC (1) selon l'une des revendications 1 à 11, **caractérisé en ce que**
- le dispositif de filtre LC (1) présente une autre bobine d'arrêt (21) de construction identique à la bobine d'arrêt (4), entourant le noyau magnétique (5), qui est reliée par sa première borne de bobine d'arrêt (21a) à la deuxième borne d'entrée (2b) et par sa deuxième borne de bobine d'arrêt (21b) à la deuxième borne de sortie (3b),
- un contact du condensateur de filtrage (8) étant relié à une autre prise (9.n/2) de la bobine d'arrêt (4) située à l'intérieur, notamment au milieu, et un autre contact du condensateur de filtrage (8) étant relié à une autre prise (9.n/2) de l'autre bobine d'arrêt (21) située à l'intérieur, notamment au milieu, et
- l'au moins une prise (9.1 - 9.n-1) de la bobine d'arrêt (4) étant reliée par l'intermédiaire de l'impédance supplémentaire (10.1 - 10.n-1) à l'au moins une prise correspondante (9.1 - 9.n-1) de l'autre bobine d'arrêt (21).

14. Dispositif de filtre LC (1) selon la revendication 13, **caractérisé en ce que** les directions de la bobine d'arrêt (4) et de l'autre bobine d'arrêt (21) sont orientées l'une par rapport à l'autre de telle sorte que le dispositif de filtre LC (1) est conçu, en ce qui concerne sa fonction de filtrage, comme une inductance de mode commun ou **en ce que** les directions de la bobine d'arrêt (4) et de l'autre bobine d'arrêt (21) sont orientées l'une par rapport à l'autre de telle sorte que le dispositif de filtre LC (1) est conçu, en ce qui concerne sa fonction de filtrage, comme une bobine d'arrêt de mode opposé.

15. Appareil électrique ou électronique, en particulier un onduleur, avec un dispositif de filtre LC (1) selon l'une des revendications précédentes.
